# EUROPEAN PATENT APPLICATION

(11) **EP 4 746 025 A1**
(43) Date of publication of application: **20.05.2026**
(21) Application number: 24842213.1
(22) Date of filing: 05.07.2024
(51) Int. Cl.: H01J 37/32

(54) **FOCUSING RING AND SEMICONDUCTOR PROCESS CHAMBER**

(30) Priority: 14.07.2023 CN 202310870346
(71) Applicant: Beijing NAURA Microelectronics Equipment Co., Ltd., Beijing 100176 (CN)
(72) Inventor: LIU, Yan, Beijing 100176 (CN); ZHOU, Ci, Beijing 100176 (CN); DONG, Zihan, Beijing 100176 (CN); WANG, Liping, Beijing 100176 (CN)
(74) Representative: LifeTech IP Spies & Behrndt Patentanwälte PartG mbB
(86) International application number: PCT/CN2024/103897
(87) International publication number: WO 2025/016218

(57) **Abstract**

Disclosed are a focusing ring (200) and a semiconductor process chamber. The focusing ring (200) includes: a ring body (10), including a first inner annular surface (11) and a first outer annular surface (12) disposed opposite to each other, and a first top surface (13) and a bottom surface (14) connecting the first inner annular surface (11) and the first outer annular surface (12) at an upper side and a lower side, respectively; an annular boss (20) disposed on the first top surface (13) and coaxially arranged with the ring body (10); where the annular boss (20) includes a second inner annular surface (21) and a second outer annular surface (22), and a second top surface (23) connecting the second inner annular surface (21) and the second outer annular surface (22) at an upper side; and a radius of the second inner annular surface (21) is greater than a radius of the first inner annular surface (11); and at least three positioning blocks (30) disposed on the first top surface (13) and configured to form a positioning circle concentric with the ring body (10) on an inner side of the at least three positioning blocks (30) to position a wafer (101), where a radius of the positioning circle is greater than the radius of the first inner annular surface (11) and less than the radius of the second inner annular surface (21) , so that the influence of an edge of the focusing ring (200) on the etching rate at an edge of the wafer (101) can be reduced, thereby improving the overall etching rate uniformity of the wafer (101).

## Description

### TECHNICAL FIELD

The present disclosure relates to the technical field of semiconductor manufacturing devices, and specifically relates to a focusing ring and a semiconductor process chamber.

### BACKGROUND

The plasma etching involves ionizing a reactive gas through high-frequency glow discharge to generate plasma, which is further chemically reacted with a material of a part of a wafer to be etched to form a volatile reactant, thereby implementing etching. During the etching process, a focusing ring is typically placed around the wafer so that the plasma can be distributed more uniformly over the entire wafer area. With the development of semiconductor devices toward miniaturization, the number of transistors at an edge of a wafer is gradually increased, and therefore, it is important to ensure a uniform etching rate from the center to the edge of the wafer.

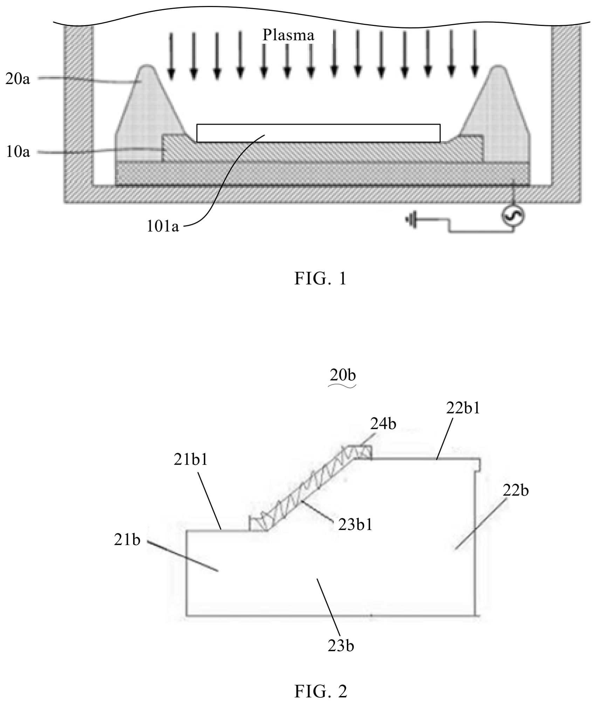

FIG. 1 shows a schematic view of an assembly structure of an existing focusing ring applied to a semiconductor process chamber. A suction disk 10a is disposed inside the semiconductor process chamber, a focusing ring 20a is sleeved outside the suction disk 10a, and a wafer 101a is fixed onto the suction disk 10a during a process, so that plasma is led to the wafer 101a by an inclined inner wall structure of the focusing ring 20a, to achieve the purpose of improving the etching rate uniformity at the edge of the wafer 101a. However, in the actual process, the semiconductor process chamber with such a structure is still prone to have poor etching rate uniformity at the edge of the wafer 101a during etching, that is, a poor effect of improving the edge etching rate uniformity, leading to non-uniform etching rates across the entire surface of the wafer 101a.

### SUMMARY

In view of the above technical problems, the present disclosure provides a focusing ring and a semiconductor process chamber, which can improve the etching rate non-uniformity across the entire wafer surface that occurs when an existing focusing ring is used during etching, due to poor etching rate uniformity at the wafer edge.

To solve the above technical problem, in a first aspect, an embodiment of the present disclosure provides a focusing ring, including:
a ring body, including a first inner annular surface and a first outer annular surface disposed opposite to each other, and a first top surface and a bottom surface connecting the first inner annular surface and the first outer annular surface at an upper side and a lower side, respectively;
an annular boss disposed on the first top surface and coaxially arranged with the ring body; wherein the annular boss includes a second inner annular surface and a second outer annular surface, and a second top surface connecting the second inner annular surface and the second outer annular surface at an upper side; and a radius of the second inner annular surface is greater than a radius of the first inner annular surface; and
at least three positioning blocks disposed on the first top surface and configured to form a positioning circle concentric with the ring body on an inner side of the at least three positioning blocks to position a wafer, wherein a radius of the positioning circle is greater than the radius of the first inner annular surface and less than the radius of the second inner annular surface.

In some embodiments, a difference between the radius of the second inner annular surface and the radius of the first inner annular surface is greater than or equal to 10 mm.

In some embodiments, the positioning blocks are uniformly distributed along a circumference of the positioning circle.

In some embodiments, the second top surface includes:
a horizontal surface connected to the second outer annular surface; and
a first inclined surface connected between the horizontal surface and the second inner annular surface.

In some embodiments, the focusing ring is made of a ceramic material.

In some embodiments, each positioning block includes:
a third top surface;
a positioning surface facing a center of the positioning circle; and
a transition surface connecting the third top surface and the positioning surface.

In some embodiments, the transition surface includes:
a second inclined surface;
a first chamfer connecting the second inclined surface and the third top surface; and
a second chamfer connecting the second inclined surface and the positioning surface.

In some embodiments, an angle between the second inclined surface and the first top surface is less than or equal to 65° and greater than or equal to 25°.

In a second aspect, an embodiment of the present disclosure provides a semiconductor process chamber, including a suction disk, and the focusing ring according to any of the above embodiments; wherein
the suction disk includes a disk body, and a cylindrical boss provided on a top surface of the disk body and configured to bear a wafer; and
the ring body is sleeved outside the cylindrical boss and supported on the top surface of the disk body, and the first top surface is lower than a top surface of the cylindrical boss.

In some embodiments, a distance between the first top surface and the top surface of the cylindrical boss is less than or equal to 0.5 mm.

In some embodiments, a difference between the radius of the first inner annular surface and a radius of the cylindrical boss is greater than 0 and less than or equal to 0.5 mm.

As described above, the focusing ring provided in the embodiments of the present disclosure includes a ring body, an annular boss and at least three positioning blocks, where the positioning blocks are located in a positioning circle, which is concentric with the ring body and configured to position the wafer, and the positioning blocks can further make a second inner annular surface of the annular boss be away from an edge of the wafer, so that the influence of an edge of the focusing ring on the etching rate at an edge of the wafer can be reduced. In addition, in the embodiments of the present disclosure, the positioning block is in point contact with the wafer, which can also effectively reduce the influence of the focusing ring on the etching rate at the edge of the wafer, and thereby improve the overall etching rate uniformity of the wafer.

### BRIEF DESCRIPTION OF DRAWINGS

The accompanying drawings, which are incorporated in and constitute a part of this specification, illustrate embodiments consistent with the present disclosure and , together with the description, serve to explain the principles of the present disclosure. To explain the technical solutions in the embodiments of the present disclosure more clearly, the drawings to be used in the description of the embodiments will be briefly described below. Apparently, other drawings may be derived from these drawings by those of ordinary skill in the art without any creative labor.
FIG. 1 is a schematic view of an assembly structure of an existing focusing ring applied to a semiconductor process chamber.
FIG. 2 is a partial structural view of another focusing ring of the existing art;
FIG. 3 is a schematic perspective view of a focusing ring according to an embodiment of the present disclosure;
FIG. 4 is a schematic front view of the focusing ring of FIG. 3;
FIG. 5 is a schematic cross-sectional view taken along line A-A of FIG. 3;
FIG. 6 is a schematic partial enlarged view of a focusing ring according to an embodiment of the present disclosure; and
FIG. 7 is a schematic structural view of a semiconductor process chamber according to an embodiment of the present disclosure.

The implementation, functional features and advantages of the objects of the present disclosure will be further explained with reference to the embodiments, and with reference to the accompanying drawings. Specific embodiments of the present disclosure have been shown by way of example in the drawings and will be described in more detail below. The drawings and written description are not intended to limit the scope of the inventive concepts in any manner, but rather to illustrate the concepts of the present disclosure to those skilled in the art with reference to specific embodiments.

### DETAIL DESCRIPTION OF EMBODIMENTS

Here, exemplary embodiments will be illustrated in detail, examples of which are shown in the accompanying drawings. The following description refers to the accompanying drawings in which the same numbers in different drawings represent the same or similar elements unless otherwise indicated. The implementations described in the following exemplary embodiments do not represent all implementations consistent with the present disclosure. Rather, they are merely examples of apparatuses and methods consistent with certain aspects of the present disclosure, as detailed in the appended claims.

It should be noted that, as used herein, the term "comprise" "include" or any variant thereof means to be non-exclusive so that a process, method, item or device including a series of elements includes not only said elements, but also other elements not explicitly listed, or inherent elements of such processes, methods, items or devices. In the absence of more limitations, an element defined by "comprising a..." does not exclude the existence of additional identical elements in the process, method, item or device including the element, and furthermore, components, features, and elements with the same name in different embodiments of the present disclosure may have the same meaning, or may have different meanings, and their specific meanings need to be explained in the specific embodiment or further combined with the context of that specific embodiment.

It should be further appreciated that the terms "comprise" and "include" specify the presence of the stated features, steps, operations, elements, components, items, types and/or groups, but not precluding the presence, appearance or addition of one or more other features, steps, operations, elements, components, items, types and/or groups. As used herein, the terms "or", "and/or", "including at least one of", and the like, are to be construed as inclusive or meaning any one or any combination of the listed items. For example, "including at least one of: A, B, C" means "any of: A; B; C; A and B; A and C; B and C; or A and B and C". For another example, "A, B or C" or " A, B and/or C" means any of: A; B; C; A and B; A and C; B and C; or A and B and C". An exception to this definition will occur only when a combination of elements, functions, steps or operations are inherently mutually exclusive in some way.

It is to be understood that although the terms "first", "second", "third", and the like may be used herein to describe various information, such information should not be limited by these terms. These terms are only used to distinguish information of the same type. For example, first information may also be referred to as second information, and similarly, second information may also be referred to as first information, without departing from the scope of the present disclosure. As used herein, the singular forms "a", "an" and "the" are intended to include the plural forms as well, depending on the context, unless the context clearly indicates otherwise.

It will be understood that the terms "top", "bottom", "upper", "lower", "vertical", "horizontal", and the like are used herein based on the orientations or positional relationships shown in the drawings, and are merely for the purposes of describing the present disclosure and simplifying the description, instead of indicting or implying that the device referred to must have a specific orientation or be configured or operated at a specific orientation, and thus should not be interpreted as limitations to the present disclosure.

For convenience of description, in the following embodiments, an orthogonal space formed by a horizontal plane and a vertical direction is taken as an example for illustration, but this precondition should not be construed as a limitation to the present disclosure.

The etching rate uniformity of a wafer may be calculated by: etching rate uniformity of wafer = (maximum rate - minimum rate)/(2 × average rate). It has been found that a semiconductor process chamber with an existing structure is prone to have poor etching rate uniformity at the edge of the wafer 101a during etching, leading to non-uniform etching rates across the entire surface of the wafer 101a, a main reason of which is that the entire inner ring edge of the focusing ring 20a is too close to the edge of the wafer 101a, and thus reduces the etching rate at the edge of the wafer 101a.

To improve the above problem, referring to FIG. 2, which is a partial structural view of another focusing ring of the existing art, a focusing ring 20b includes: a first portion 21b made of a silicon-containing material and surrounding the wafer, a second portion 22b made of an yttrium-containing material and surrounding an outside of the first portion 21b. The first portion 21b and the second portion 22b are connected by a third portion 23b. A top surface 21b1 of the first portion 21b and a top surface 22b1 of the second portion 22b are both parallel to a horizontal plane, and the top surface 21b1 of the first portion 21b is lower than the top surface 22b1 of the second portion 22b. The top surface 21b1 of the first portion 21b and the top surface 22b1 of the second portion 22b are connected by a transition inclined surface 23b at a top of the third portion 23b, and the transition inclined surface 23b1 is provided with a SiC coating 24b. This improvement scheme improves the etching rate uniformity at the wafer edge by making the top of the focusing ring 20b have different materials at different positions in the radial direction. However, such a structure is made of multiple materials in a composite mode, which involves a certain difficulty in processing and relatively high cost, while a wafer positioning function is lost, and if the position of the wafer is offset, the overall etching rate uniformity of the wafer may also be affected to some extent.

In view of this, the present disclosure provides a focusing ring and a semiconductor process chamber.

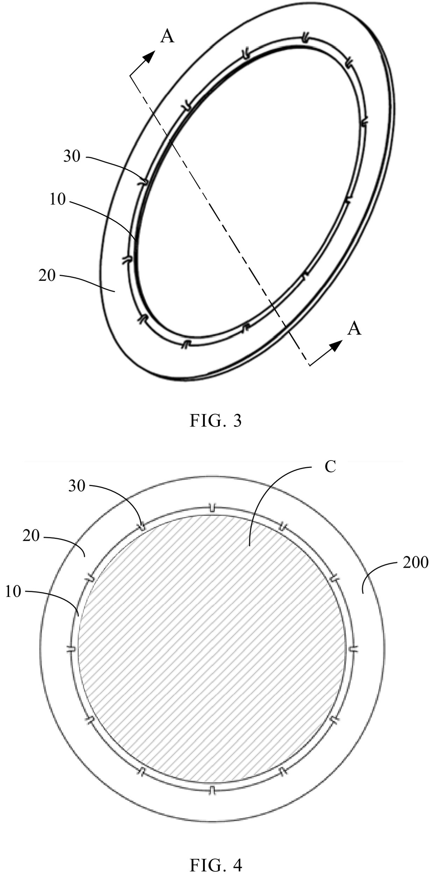

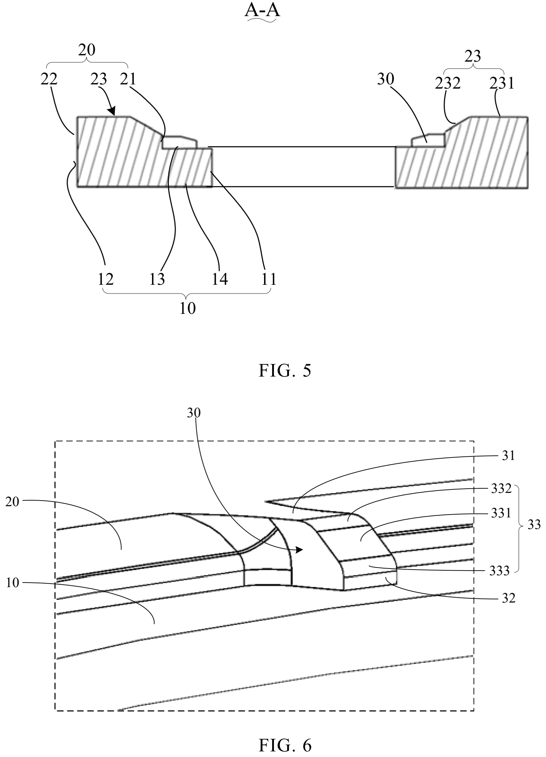

Referring to FIGs. 3 to 5, FIG. 3 is a schematic perspective view of a focusing ring according to an embodiment of the present disclosure, FIG. 4 is a schematic front view of the focusing ring of FIG. 3, and FIG. 5 is a schematic cross-sectional view taken along line A-A of FIG. 3. A focusing ring 200 includes a ring body 10, an annular boss 20 and at least three positioning blocks 30.

Referring to FIG. 5, the ring body 10 includes a first inner annular surface 11 and a first outer annular surface 12 disposed opposite to each other, and a first top surface 13 and a bottom surface 14 connecting the first inner annular surface 11 and the first outer annular surface 12 at an upper side and a lower side, respectively. The annular boss 20 is disposed on the first top surface 13 and coaxially arranged with the ring body 10. The annular boss 20 includes a second inner annular surface 21 and a second outer annular surface 22, and a second top surface 23 connecting the second inner annular surface 21 and the second outer annular surface 22 at an upper side. A radius of the second inner annular surface 21 is greater than a radius of the first inner annular surface 11. It should be noted that the ring body 10 and the annular boss 20 may be integrally formed. For example, the whole focusing ring 200 may be made of a ceramic material and integrally sintered, but the material used for the focusing ring 200 is not limited thereto. As some examples, the ceramic material may be Al₂O₃ ceramic, quartz, or the like. The second inner annular surface 21 of the annular boss 20 extends outward with respect to the first inner annular surface 11 of the ring body 10, so that an inner side surface of the focusing ring 200 forms a step surface. The second outer annular surface 22 of the annular boss 20 may be flush, or not flush, with the first outer annular surface 12 of the ring body 10. In addition, the second outer annular surface 22 and the second top surface 23 of the annular boss 20, and the bottom surface 14 and the first outer annular surface 12 of the ring body 10, may be planes, inclined surfaces, or irregular surfaces such as step surfaces, which is not particularly limited in the embodiments of the present disclosure.

Referring to FIGs. 4 and 5, the at least three positioning blocks 30 (12 positioning blocks are shown in the figures) are all disposed on the first top surface 13 of the ring body 10, and configured to form a positioning circle C concentric with the ring body 10 on an inner side of the at least three positioning blocks 30. The "inner side" refers to a side of the at least three positioning blocks 30 close to a center of the ring body 10. A radius of the positioning circle C is greater than the radius of the first inner annular surface 11 and less than the radius of the second inner annular surface 21. It should be noted that since the positioning circle C is configured to position a wafer, the radius of the positioning circle C only needs to be slightly greater than a radius of the wafer. In some embodiments, the at least three positioning blocks 30 are sequentially connected at their respective ends close to the center of the ring body 10 to form a polygon, and a center of the positioning circle C is located inside the polygon. For example, the positioning circle C is a circle circumscribing the polygon. For example, when only three positioning blocks 30 are provided, the three positioning blocks 30 are sequentially connected at their respective ends close to the center of the ring body 10 to form a triangle with three acute apex angles, so that the center of the positioning circle C can be located inside the triangle, and the situation that the three positioning blocks 30 are too dense to position the wafer from three directions is avoided. Similarly, when four positioning blocks 30 are provided, the center of the positioning circle C is located inside a quadrangle formed by sequentially connecting the four positioning blocks 30 at their respective ends close to the center of the ring body 10. Preferably, all the positioning blocks 30 are uniformly distributed along a circumference of the positioning circle C.

The existing focusing ring shown in FIG. 1 is in surface contact with the wafer, where the etching rate at the edge of the wafer is greatly influenced by the focusing ring, and the focusing ring is close to the wafer and is too high, tending to cause eddy currents above the edge of the wafer, and making the plasma difficult to enter a gap between the focusing ring and the wafer, both of which may greatly reduce the etching rate at the edge of the wafer. In the focusing ring 200 of this embodiment, by providing the positioning blocks 30 to form the positioning circle C that positions the wafer and position the wafer inside the positioning circle C, the second inner annular surface 21 of the annular boss 20 is far away from an edge of the wafer, so that the influence of an edge of the focusing ring 200 on the etching rate at the edge of the wafer can be reduced. Moreover, in this embodiment, the positioning block 30 is in point contact with the wafer, which can also effectively reduce the influence of the focusing ring 200 on the etching rate at the edge of the wafer, and thereby improve the overall etching rate uniformity of the wafer. In addition, the structure of the focusing ring 200 is improved in this embodiment, and the focusing ring 200 may be made of the same material, such as Al₂O₃ or quartz, or other ceramic materials. Compared with the improvement scheme in FIG. 2, the focusing ring 200 of this embodiment has a more mature manufacturing process and lower cost.

In an embodiment, a difference between the radius of the second inner annular surface 21 of the annular boss 20 and the radius of the first inner annular surface 11 of the ring body 10 is greater than or equal to 10 mm. That is, the second inner annular surface 21 is extended outward by 10 mm or more from the first inner annular surface 11 at a single side. By comparing electric field simulation results and process results of different sizes, it can be seen that the influence of an edge of the focusing ring 200 on the etching rate at the edge of the wafer can be effectively reduced under such conditions, thereby achieving a better effect of improving the etching rate uniformity at the edge of the wafer.

In an embodiment, with continued reference to FIG. 5, the second top surface 23 of the annular boss 20 may include a horizontal surface 231 and a first inclined surface 232. The horizontal surface 231 is connected to the second outer annular surface 22, the first inclined surface 232 is connected between the horizontal surface 231 and the second inner annular surface 21, and the first inclined surface 232 may be connected to the horizontal surface 231 and the second inner annular surface 21 through transition of a fillet. In this embodiment, the first inclined surface 232, as a transition surface between the horizontal surface 231 and the second inner annular surface 21, can enable a smooth transition between the horizontal surface 231 and the second inner annular surface 21, so that an electric field can be effectively adjusted, the distribution of plasma can be controlled, the uniformity of plasma distributed at the edge of the wafer can be improved, and the etching rate uniformity at the edge of the wafer can be improved.

In an embodiment, referring to FIG. 6, a schematic partial enlarged view of a focusing ring according to an embodiment of the present disclosure is shown. Each positioning block 30 may include a third top surface 31, a positioning surface 32, and a transition surface 33. The positioning surface 32 faces a center of the positioning circle C, and may be a vertical surface. The transition surface 33 connects the third top surface 31 and the positioning surface 32, and may be an inclined surface. The position of the wafer can be finely adjusted by the transition surface 33. For example, when deviating from the center of the positioning circle C during falling, a wafer can slide along the transition surface 33 to fall within an area of the positioning circle C.

In an embodiment, the transition surface 33 may include a second inclined surface 331, a first chamfer 332, and a second chamfer 333. The first chamfer 332 connects the second inclined surface 331 and the third top surface 31, and the second chamfer 333 connects the second inclined surface 331 and the positioning surface 32. In other words, the second inclined surface 331 may be connected to the third top surface 31 through transition of the first chamfer 332, and connected to the positioning surface 32 through transition of the second chamfer 333, so that the wafer can be prevented from being scratched by sharp corners in the falling process. For example, an angle between the second inclined surface 331 and the first top surface 13 may be less than or equal to 65° and greater than or equal to 25°, to ensure that the wafer can smoothly slide onto the positioning circle C when deviating from the center of the positioning circle C.

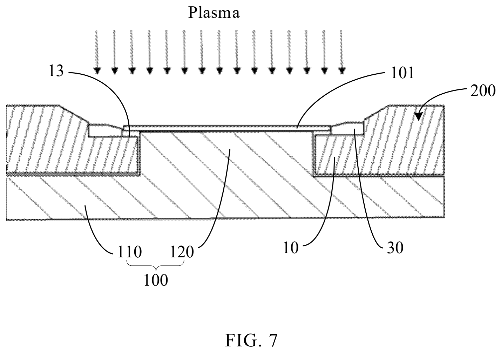

An embodiment of the present disclosure further provides a semiconductor process chamber. Referring to FIG. 7, which is a schematic structural view of a semiconductor process chamber according to an embodiment of the present disclosure, the semiconductor process chamber includes a suction disk 100, and the focusing ring 200 according to any of the above embodiments. A chamber body of the semiconductor process chamber is not shown in the figure.

The suction disk 100 includes a disk body 110, and a cylindrical boss 120 provided on a top surface of the disk body 110 and configured to bear a wafer 101. The ring body 10 of the focusing ring 200 is sleeved outside the cylindrical boss 120 and supported on the top surface of the disk body 110, and the first top surface 13 of the ring body 10 is lower than a top surface of the cylindrical boss 120. Specifically, a diameter of the wafer 101 is greater than a diameter of the cylindrical boss 120, and an edge portion of the wafer 101 extends out of the cylindrical boss 120 and is suspended above the first top surface 13 of the ring body 10. The positioning circle C formed by the at least three positioning blocks 30 of the focusing ring 200 at the inner side thereof is used to position the wafer 101.

As an example, a distance between the first top surface 13 of the ring body 10 of the focusing ring 200 and the top surface of the cylindrical boss 120 is less than or equal to 0.5 mm. In other words, the top surface of the cylindrical boss 120 is higher than the first top surface 13 of the ring body 10 by no more than 0.5 mm, which ensures that an edge portion of the wafer 101 is suspended above the ring body 10, and a gap between the two is not too large to affect the plasma density at the edge of the wafer 101 and reduce the etching rate at an edge region of the wafer 101.

To facilitate the installation and fitting accuracy between the ring body 10 and the cylindrical boss 120, as an example, a difference between the radius of the first inner annular surface 11 of the ring body 10 and a radius of the cylindrical boss 120 is greater than 0 and less than or equal to 0.5 mm, and the two are in a clearance fit with a clearance less than or equal to 0.5 mm.

For other working principles of the semiconductor process chamber of this embodiment, reference may be made to the foregoing description of the focusing ring in the embodiments of the present disclosure, which is not repeated here.

The foregoing has described in detail a focusing ring and a semiconductor process chamber provided in the present disclosure, where specific examples are applied herein to explain the principles and implementations of the present disclosure. It should be noted that, in the present disclosure, the description of each embodiment has its own emphasis, and for parts that are not described or recited in detail in a certain embodiment, reference may be made to the related description in other embodiments.

The technical features in the technical solutions of the present disclosure can be combined in any way, and not all possible combinations of the technical features in the above embodiments are described for the sake of brevity, but they should be considered as being within the scope of the present disclosure as long as the combinations of the technical features are not contradictory.

## Claims

1. A focusing ring, comprising:
a ring body, comprising a first inner annular surface and a first outer annular surface disposed opposite to each other, and a first top surface and a bottom surface connecting the first inner annular surface and the first outer annular surface at an upper side and a lower side, respectively;
an annular boss disposed on the first top surface and coaxially arranged with the ring body; wherein the annular boss comprises a second inner annular surface and a second outer annular surface, and a second top surface connecting the second inner annular surface and the second outer annular surface at an upper side; and a radius of the second inner annular surface is greater than a radius of the first inner annular surface; and
at least three positioning blocks disposed on the first top surface and configured to form a positioning circle concentric with the ring body on an inner side of the at least three positioning blocks to position a wafer, wherein a radius of the positioning circle is greater than the radius of the first inner annular surface and less than the radius of the second inner annular surface.

2. The focusing ring according to claim 1, wherein a difference between the radius of the second inner annular surface and the radius of the first inner annular surface is greater than or equal to 10 mm.

3. The focusing ring according to claim 1, wherein the at least three positioning blocks are uniformly distributed along a circumference of the positioning circle.

4. The focusing ring according to claim 1, wherein the second top surface comprises:
a horizontal surface connected to the second outer annular surface; and
a first inclined surface connected between the horizontal surface and the second inner annular surface.

5. The focusing ring according to claim 1, wherein the focusing ring is made of a ceramic material.

6. The focusing ring according to any one of claims 1 to 5, wherein each of the at least three positioning blocks comprises:
a third top surface;
a positioning surface facing a center of the positioning circle; and
a transition surface connecting the third top surface and the positioning surface.

7. The focusing ring according to claim 6, wherein the transition surface comprises:
a second inclined surface;
a first chamfer connecting the second inclined surface and the third top surface; and
a second chamfer connecting the second inclined surface and the positioning surface.

8. The focusing ring according to claim 7, wherein an angle between the second inclined surface and the first top surface is less than or equal to 65° and greater than or equal to 25°.

9. A semiconductor process chamber, comprising a suction disk, and the focusing ring according to any of claims 1 to 8; wherein
the suction disk comprises a disk body, and a cylindrical boss provided on a top surface of the disk body and configured to bear a wafer; and
the ring body is sleeved outside the cylindrical boss and supported on the top surface of the disk body, and the first top surface is lower than a top surface of the cylindrical boss.

10. The semiconductor process chamber according to claim 9, wherein a distance between the first top surface and the top surface of the cylindrical boss is less than or equal to 0.5 mm.

11. The semiconductor process chamber according to claim 9, wherein a difference between the radius of the first inner annular surface and a radius of the cylindrical boss is greater than 0 and less than or equal to 0.5 mm.
